# EUROPÄISCHE PATENTSCHRIFT

(11) **EP 1 719 156 B1**
(45) Veröffentlichungstag und Bekanntmachung des Hinweises auf die Patenterteilung: **20.06.2007**
(21) Anmeldenummer: 05715007.0
(22) Anmeldetag: 22.02.2005
(51) Int. Cl.: H01L 21/00, B23K 20/00, H05K 3/06

(54) **VORRICHTUNG ZUM SINGULIEREN UND BONDEN VON HALBLEITERCHIPS UND VERFAHREN ZUM SINGULIEREN UND BONDEN**
DEVICE FOR SINGULATING AND BONDING SEMICONDUCTOR CHIPS, AND SINGULATING AND BONDING METHOD
DISPOSITIF POUR ISOLER ET SOUDER DES PLAQUETTES SEMI-CONDUCTRICES ET PROCEDE D'ISOLEMENT ET DE SOUDAGE

(30) Priorität: 26.02.2004 DE 102004009901
(43) Veröffentlichungstag der Anmeldung: 08.11.2006
(73) Patentinhaber: Infineon Technologies AG, 81669 München (DE)
(72) Erfinder: LEHNER, Rudolf, 93164 Laaber (DE)
(74) Vertreter: Schäfer, Horst
(86) Internationale Anmeldenummer: PCT/DE2005/000301
(87) Internationale Veröffentlichungsnummer: WO 2005/083748

(56) Entgegenhaltungen:
- WO-A-03/089305
- US-A- 4 472 218
- US-A- 5 062 565
- US-A- 5 897 049
- US-A- 6 142 356

## Beschreibung

Die Erfindung betrifft eine Vorrichtung zum Singulieren und Bonden von Halbleiterchips und bezieht sich auf ein Verfahren zum Singulieren und Bonden. Dazu weist die Vorrichtung eine Singulierstation und eine Bestückungsstation auf.

Aus der Druckschrift US 5,062,565 ist ein System für die Herstellung von Halbleiterbauteilen bekannt. Mit diesem System wird ein Verfahren zur Kombination des Bestückungsverfahrens mit Halbleiterchips und des Drahtbondens von Halbleiterchips beim Zusammenbau eines Halbleitergehäuses verwirklicht. Dazu wird eine konventionelle Halbleiterchip-Bestückungseinrichtung und eine Halbleiterchip-Drahtbondeinrichtung in ein vereinfachtes, gemeinsames Maschinensystem integriert. Ein unabhängig montiertes, computerüberwachtes Fernsehkamerasystem beobachtet und überwacht die Arbeitsschritte.des Halbleiterchipbestückungs- und des Drahtbondprozesses unter Einsatz von Rückkopplungsprozessen.

Der Nachteil dieses Systems und Verfahrens besteht darin, dass eine konventionelle Singuliervorrichtung mit einer Vakuumpipette eingesetzt wird, wie sie aus der Druckschrift JP 62-005837 und DE 102 17 792 A1 für großflächige Halbleiterchips bekannt ist. Derartige Vakuumpipetten erfordern zum Singulieren eine Mindestflächengröße eines Halbleiterchips, da sonst der Halbleiterchip nicht von der Vakuumpipette aufgenommen und einer Bestückungsstation zugeführt werden kann. Ein Singulieren und Befördern von Halbleiterchips, deren Oberfläche diese Mindestflächengröße unterschreitet ist nicht, möglich.

Es besteht jedoch der Bedarf, insbesondere in der Hochfrequenztechnik, diskrete HF-Halbleiterbauteile, insbesondere HF-PIN-Dioden zu bauen, deren Halbleiterchips um mindestens eine Größenordnung kleiner sind, als die oben erwähnte Mindestflächengröße zur Handhabung derartiger Halbleiterchips in einer Singulierstation eines in Halbleiterchips aufgetrennten Halbleiterwafers.

Aufgabe der Erfindung ist es, eine Vorrichtung und ein Verfahren anzugeben, das es ermöglicht, auch noch Halbleiterchips, deren Oberfläche um eine Größenordnung kleiner ist, als die Mindestflächengröße von Halbleiterchips herkömmlicher Singuliervorrichtungen, aufzunehmen und einer Bestückungseinrichtung zuzuführen. Insbesondere sollen Hochfrequenzhalbleiterbauteile und HF-PIN-Dioden für Hochfrequenzanwendungen in entsprechende Hochfrequenzgehäuse kostengünstig eingebaut werden.

Diese Aufgabe wird mit dem Gegenstand der unabhängigen Ansprüche gelöst. Vorteilhafte Weiterbildungen der Erfindung ergeben sich aus den abhängigen Ansprüchen.

Erfindungsgemäß wird eine Vorrichtung zum Singulieren und Bonden von Halbleiterchips geschaffen. Diese Vorrichtung weist eine Singulierstation und eine Bestückungsstation auf und verfügt über einen Hub- und Transportmechanismus. Die Singulierstation ist für Halbleiterchips eines Halbleiterwafers mit einem Bondwerkzeug zum fixieren eines Bonddrahtes auf einem Halbleiterchip ausgestattet. Ferner weist die Singulierstation eine Abhebevorrichtung zum Abheben eines Halbleiterchips von einer mit Halbleiterchips eines Halbleiterwafers bedeckten Trägerfolie auf.

Das Bondwerkzeug und die Abhebeeinrichtung sind einander gegenüberliegend angeordnet und derart ausgerichtet, dass ein Halbleiterchip auf einem Singuliertisch zwischen dem Bondwerkzeug und einer Hubeinrichtung der Abhebeeinrichtung angeordnet ist. Um Bondwerkzeug und Abhebeeinrichtung auf einen Halbleiterchip auszurichten, kann entweder ein Bewegen des Halbeiterwafers auf dem Singuliertisch in x- und y-Richtung, oder orthogonal zu der Bewegungsrichtung des Bondwerkzeugs und der Hubeinrichtung erfolgen, oder es wird das Bondwerkzeug und die Hubvorrichtung in x- und y-Richtung verschoben.

Die Bestückungsstation weist einen Schaltungsträger auf, der eine Chipmontagefläche zur Aufnahme eines an einem Bonddraht des Bondwerkzeuges gebondeten Halbleiterchip aufweist. Darüber hinaus weist der Schaltungsträger in der Bestückungsstation mindestens eine Kontaktanschlussfläche zum Aufbonden des Bonddrahtes des Bondwerkzeugs auf diese Kontaktanschlussfläche auf. Schließlich besitzt die erfindungsgemäße Vorrichtung einen Hub- und Transportmechanismus mit einer Steuerungsvorrichtung zum Steuern und Ausführen von Bewegungen des Bondwerkzeuges, des Simuliertisches, der Abhebeeinrichtung und des Schaltungsträgers.

Die Mindestflächengröße für einen Halbleiterchip, der mit dieser Vorrichtung gebondet, singuliert und transportiert werden kann, vermindert sich um mehr als eine Größenordnung gegenüber herkömmlichen Singuliervorrichtungen. Da der Durchmesser der Bonddrähte bis auf 15 Mikrometer nach heutigem Stand der Technik verkleinert werden kann, vermindert sich die Mindestflächengröße auf die Aufnahme und für den Transport eines Halbleiterchips bei einer Kontaktflächengröße von etwa 35x35 Mikrometern. Wird noch ein Sägeabstand für die Sägespuren hinzugerechnet, damit sich Mikrorisse nicht bis in den aktiven Bereich des Halbleiterchip fortpflanzen können, dann liegen die Außenmaße eines derartigen Halbleiterchips, der noch mit dieser erfindungsgemäßen Vorrichtung bearbeitet werden kann, bei einer Kantenlänge von etwa 70 Mikrometern.

Derartige minimale Abmessungen, wie sie beispielsweise bei diskreten Hochfrequenzhalbleiterbauteilen HF-PIN-Dioden auftreten, können mit der erfindungsgemäßen Anlage separiert und gleichzeitig können Thermokompressionsköpfe auf die Oberseite des Halbleiterchips auf eine der Kontaktflächen dieser Oberseite fixiert werden. Der Bonddraht, der später gleichzeitig zum elektrischen Verbinden des Halbleiterchips auf einem Schaltungsträger mit einer übergeordneten Schaltungsplatine vorgesehen ist, dient hier beim Singulieren dazu, den Halbleiterchip aus seiner Position auf dem Singuliertisch abzuheben. Dazu kann das Bondwerkzeug eine zentrale Bondkanüle oder einen zentralen Hohlstichel aufweisen, in dem ein Bonddraht angeordnet ist. Oberhalb der Bondkanüle bzw. des Bondstichels ist in dem Bondwerkzeug eine Klemmvorrichtung eingebaut, die in ihrem geöffneten Zustand ein Nachlaufen des Bonddrahtes durch die Bondkanüle ermöglicht, und im geklammerten Zustand den Bonddraht in der Kanüle auf einer festgelegten Länge fixiert.

Zu dem Bondwerkzeug gehört auch eine Abschmelzeinrichtung, mit welcher der Bonddraht an seinem frei aus der Kanüle herausstehenden Ende zu einer Bondperle abgeschmolzen werden kann. Diese Abschmelzeinrichtung kann einen Flammengenerator oder einen Funkengenerator umfassen, der das Abschmelzen des Bonddrahtes und das Bilden einer Bondperle bewirkt. Andere Ausführungsformen der Abschmelzeinrichtung sehen Induktionsspulen vor, die den Bonddraht bis zum Abschmelzen und Bilden einer Bondperle aufheizen.

Das Bondwerkzeug ist oberhalb des Separiertisches in vertikaler Richtung verschieblich. Damit kann das Bondwerkzeug beim Bonden auf einer Kontaktfläche der aktiven Oberseite des Halbleiterchips in vertikaler z-Richtung nach Ausrichten in x- und y-Richtung auf einen Halbleiterchips abgesenkt und der Bondvorgang durchgeführt werden. Dazu kann ein Ultraschall unterstütztes Thermokompressionsbonden die gebildete Bondperle mit dem Metall der Kontaktfläche verbindet. Ferner können eutektische Verbindungen entstehen, die nach dem Bondvorgang eine so hohe Abreißfestigkeit aufweisen, dass der Halbleiterchip an dem Bonddraht hängend, von der Trägerfolie abgehoben werden kann. Jedoch sind die Adhäsionskräfte dieser Trägerfolie üblicherweise derart hoch, dass die Gefahr besteht, dass der dünne Bonddraht reißt.

Deshalb ist in einer weiteren bevorzugten Ausbildung der Erfindung vorgesehen, dass die Abhebeeinrichtung unterhalb der Folie angeordnet ist, und eine Hubnadel aufweist, die auf den abzuhebenden Halbleiterchip ausgerichtet ist. Nach dem Bonden kann diese Hubnadel die Trägerfolie durchstechen und den Halbleiterchip von der Trägerfolie abheben, während er bereits an dem Bondwerkzeug hängt. Um das Lösen von der Trägerfolie zu erleichtern, kann die Abhebevorrichtung eine Heizvorrichtung aufweisen, welche auf die Trägerfolie im Bereich des abzuhebenden Halbleiterchips ausgerichtet ist. Diese Variante wird in den Fällen vorteilhaft eingesetzt, in denen die Trägerfolie eine Klebeschicht aus einem Thermoplast aufweist, der unter der Wärmeeinwirkung der Heizvorrichtung aufschmilzt.

Vorzugsweise weist die Abhebeeinrichtung sowohl eine Heizvorrichtung, als auch eine Hubnadel auf, um das Abheben von der Trägerfolie zu erleichtern. Ein thermoplastischer Klebstoff auf der Trägerfolie hat darüber hinaus den Vorteil, dass die Unterseite des Halbleiterchips beim Abheben mit einem Thermoplast benetzt bleibt, so dass ein Aufsetzen des Halbleiterchips und ein Bestücken eines Schaltungsträgers mit dem Halbleiterchip in einer Bestückungsstation erleichtert wird. Die Bestückungsstation weist austauschbare Halter für unterschiedliche Schaltungsträgerkonstruktionen auf. Prinzipiell hat jeder Schaltungsträger, wie oben erwähnt, eine Chipmontagefläche, auf welche der an dem Bonddraht hängende Chip montiert werden kann. Darüber hinaus weist der Schaltungsträger mindestens eine Kontaktfläche auf, die elektrisch von der Chipmontagefläche getrennt ist, wobei die elektrische Verbindung zum Halbleiterchip dann über den Bonddraht mit Hilfe des Bondwerkzeuges geschaffen wird. Der auswechselbare Halter kann einen Flachleiterrahmen als Schaltungsträger aufweisen, bei dem eine Chipinsel die Chipmontagefläche bildet und ein Innenflachleiter die Kontaktanschlussfläche aufweist.

In einer weiteren bevorzugten Ausführungsform der Erfindung ist es vorgesehen, dass die Bestückungsstation einen Halter für einen Nutzen aufweist. Der hier als Schaltungsträger eingesetzte Nutzen weist mehrere in Zeilen und Spalten angeordnete Bauteilpositionen mit jeweils einer Halbleiterchipfläche und entsprechenden Kontaktanschlussflächen in den Halbleiterbauteilpositionen auf.

Weiterhin kann die Bestückungsstation einen Halter für ein Umverdrahtungssubstrat aufweisen, das als Schaltungsträger zum Bestücken mit einem Halbleiterchip zur Verfügung steht.

Ein Umverdrahtungssubstrat besitzt gegenüber einem selbsttragenden, metallischen Flachleiterrahmen eine Tragstruktur aus Kunststoff oder Keramik. Dieses Umverdrahtungssubstrat weist auf seiner Oberseite metallische Umverdrahtungsstrukturen in Form von einer dünnen Metallschicht auf, die zu einer Bondinsel bzw. zu Kontaktanschlussflächen strukturiert ist. Zum Bestücken derartiger Umverdrahtungssubstrate wird in der erfindungsgemäße Vorrichtung lediglich der Halter für den Schaltungsträger ausgewechselt.

Insbesondere weist die Vorrichtung in der Bestückungsstation einen Halter für ein Hochfrequenzgehäuse auf, das als Schaltungsträger mit einem Halbleiterchip bestückt werden kann. Dieses Hochfrequenzgehäuse kann ein Hochfrequenz PIN-Diodengehäuse sein, das aus Metallstrukturen und keramischen Isolationskomponenten aufgebaut ist, wobei der Kathodenanschluss durch die Chipmontagefläche und der Anodenanschluss durch die Kontaktanschlussfläche gebildet werden.

Ein Verfahren zum Singulieren und Bonden von Halbleiterchips eines in Halbleiterchips aufgetrennten Halbleiterwafers weist die nachfolgenden Verfahrensschritte auf. Zunächst wird ein Halbleiterwafer, der auf einer Trägerfolie fixiert ist und in Halbleiterchips aufgetrennt ist, auf einem Singuliertisch einer Singulierstation positioniert. Anschließend wird ein Bondwerkzeug mit einem Bonddraht über dem Halbleiterchip auf dem Singuliertisch ausgerichtet. Anschließend wird mittels einer Abschmelzeinrichtung eine Bondperle am Ende des Bonddrahtes gebildet, und das Bondwerkzeug in Richtung auf den Halbleiterchip abgesenkt. Dabei wird die Bondperle auf eine Kontaktfläche des Halbleiterchips aufgebondet.

Anschließend wird das Bondwerkzeug mit dem am Bonddraht hängenden Halbleiterchip von der Trägerfolie abgehoben. Dieses Abheben kann durch eine Abhebevorrichtung, die unterhalb des Separiertisches angeordnet ist, unterstützt werden. Dazu kann die Abhebevorrichtung unterhalb der Trägerfolie eine Hubnadel aufweisen, die zur Unterstützung des Abhebens des Halbleiterchips durch die Trägerfolie hindurch sticht. Darüber hinaus kann im Bereich des abzuhebenden Halbleiterchips die Abhebeeinrichtung unterhalb der Trägerfolie eine Heizvorrichtung aufweisen, die im Bereich des abzuhebenden Halbleiterchips die Trägerfolie und damit die Adhäsionsschicht auf der Trägerfolie aufheizt, wodurch das Abheben des an dem Bonddraht hängenden Halbleiterchips erleichtert wird.

Anschließend wird der Halbleiterchips an dem Bonddraht des Bondwerkzeuges zu einer Bestückungsstation transportiert, die einen Schaltungsträger mit einer Chipmontagefläche und mindestens eine Kontaktanschlussfläche aufweist. Durch Absenken des Bondwerkzeuges wird der Halbleiterchip an dem Bonddraht auf der Montagefläche abgesetzt und mit dieser fixiert. Schließlich wird durch Öffnen der Klammereinrichtung des Bondwerkzeuges der Bonddraht freigegeben und in einem Bondbogen auf die Kontaktanschlussfläche mit Hilfe des Bondwerkzeug geführt. Durch Thermokompressionsbonden, das mittels Ultraschall unterstützt sein kann, wird nun der Bondbogen auf der Kontaktanschlussfläche fixiert, unter Schließen der Klammereinrichtung des Bondwerkzeugs kann der Draht von der Bondstelle weg- und abgerissen werden.

Diese Verfahren kann nun so oft wiederholt werden, bis sämtliche Halbleiterchips des Halbleiterwafers in der Separierposition von der Trägerfolie separiert sind, und in der Bestückungsstation auf entsprechende Schaltungsträger aufgebracht und dort elektrisch mit entsprechenden Kontaktanschlussflächen über Bonddrähte verbunden sind. Bei einer diskreten Bauteilfertigung kann der Halbleiterchip in ein Keramikhohlgehäuse beim Bestücken eingebracht werden, oder er kann nach dem Bestücken in eine Kunststoffgehäusemasse eingebettet werden. Der jeweilige Schaltungsträger kann Außenkontakte aufweisen, mit denen die Chipmontagefläche und die Kontaktanschlussfläche über Außenkontaktflächen des Halbleiterbauteils verbunden sind.

Andererseits kann unter Einsatz eines Flachleiterrahmenstreifens dieser Vorgang des Bestückens zunächst auf dem gesamten Flachleiterstreifen durchgeführt werden und anschließend ein entsprechendes Packaging-Verfahren durchgeführt werden, bei dem die gebondeten Halbleiterchips in Gehäuse eingebettet werden. Stehen für das Anbringen der Halbleiterchips sogenannte Nutzen oder eine Keramikplatte zur Verfügung, so können nacheinander sämtliche Halbleiterpositionen eines Nutzens oder einer Keramikplatte mit entsprechenden Halbleiterchips versehen werden, nach Aufbringen einer gemeinsamen Kunststoff- oder Keramikabdeckung können der Nutzen oder die Keramikplatte zu Einzelbauteilen aufgetrennt werden.

In einer bevorzugen Durchführungsform des Verfahrens wird vor dem Positionieren des Halbleiterwafers ein Auftrennen des Halbleiterwafers in Halbleiterchips auf dem Singuliertisch mittels Diamantsägen erfolgen. Dies hat den Vorteil, dass ein Aufkleben und Abkleben des Halbleiterchips auf seiner Trägerfolie von dem Singuliertisch unterbleibt. Dabei dient der Singuliertisch gleichzeitig als Sägetisch und ist dementsprechend strukturiert. Somit kann der Tisch von einer Sägeposition zu der Singulierstation der vorliegenden Vorrichtung ohne Ablösen des Halbleiterwafers von seiner Trägerfolie transportiert werden.

Um den Verfahrenszyklus der erfindungsgemäßen Vorrichtung durchführen zu können, wird am Anfang des Verfahrens, vor einem Ausrichten des Bondwerkzeugs über einem der Halbleiterchips auf dem Singuliertisch, ein Bonddraht in eine zentrale Bondkanüle des Bondwerkzeugs eingeführt. Diese Bondkanüle kann auch als Bondstichel ausgebildet sein, der an seiner Spitze eine spezielle Form ausweist, um beispielsweise einen Bondbogen zu realisieren.

Zum Bilden einer Bondperle am Ende eines Bonddrahtes wird vorzugsweise eine Flamme oder ein Zündfunke auf das Bonddrahtende gerichtet. Dabei wird so viel Energie übertragen, dass sich eine nahezu kugelförmige Bondperle ausbildet. Bei einer weiteren Durchführung des Verfahrens ist es vorgesehen, die Bondperle mittels induktivem Heizen zu bilden.

Das Fixieren des Halbleiterchips auf der Chipmontagefläche in der Bestückungsstation der Vorrichtung kann einerseits durch Andrücken des Bondwerkzeugs mit dem an seiner Spitze befindlichen Halbleiterchip auf eine Klebstoffschicht auf der Chipmontagefläche erfolgen, wobei Kraft von dem Bondwerkzeug auf den Halbleiterchip über den Thermokompressionskopf des Bonddrahtes übertragen wird. Eine weitere Variante sieht vor, dass zum Fixieren des Halbleiterchips auf der Chipmontagefläche mittels des Bondwerkzeuges ein Aufheizen einer Lotschicht auf der Chipmontagefläche erfolgt, und gleichzeitig ein Andrücken des Halbleiterchips mit Hilfe des Bondwerkzeuges auf die angeschmolzene Lotschicht durchgeführt wird.

Zusammenfassend ist festzustellen, dass bei herkömmlichen Vorrichtungen ein Problem des Bestückungsprozesses mit kleinen Halbleiterchips, bei Kantenlängen unterhalb eines Millimeters auftritt. Dieses Problem besteht darin, dass die konventionell eingesetzten Vakuumpipetten aufgrund der geringen Dimensionen ihrer Vakuumkanülen nur geringe Standzeiten aufweisen und damit die Kosten des Verfahrens zur Bestückung von Schaltungsträgern mit kleinen Halbleiterchips exponentiell mit der Abnahme der Fläche der Halbleiterchips zunehmen.

Ferner gibt es ein technisches Limit der Größe dieser Bondwerkzeuge mit einer Vakuumbohrung, da diese einen Mindestdurchmesser von etwa 100 Mikrometern aufweist, der für den Transport des Halbleiterchips von der Separierposition zu einer Bestückungsstation erforderlich ist. Da die Bohrung im Bereich von 100 Mikrometern liegt, ist die Grenze für den minimalen Außendurchmesser der Vakuumpipette bei etwa 200 Mikrometern. Somit können Halbleiterchips mit einer Kantenlänge unter 200 Mikrometern mit herkömmlichen Separier- und Bestückungsanlagen nicht mehr bearbeitet werden.

Die Standzeiten für kleinere Vakuumpipetten, die eine Kantenlänge von 150 Mikrometern zulassen, sind derart gering, dass diese Vakuumpipetten nicht einmal einen einzelnen, in Halbleiterchips getrennten, Halbleiterwafer von 30 cm Durchmesser vollständig bearbeiten können, da die Standzeit von derart feinen Vakuumpipetten unter 10.000 Stück pro Pipette fällt, und ein derartiger Halbleiterwafer mehrere 100.000 Halbleiterchips aufweist. In der vorliegenden Erfindung wird die Funktion der Vakuumpipetten von einem Bondwerkzeug übernommen, wobei derartige Werkzeuge in der Lage sind, Bonddrähte von 15 Mikrometer Durchmesser auf Kontaktanschlussflächen von einigen 10 Mikrometern Kantenlänge aufzubringen.

Somit ist es nun möglich die Miniaturisierung von diskreten Halbleiterbauteilen, wie HF-PIN-Dioden für die Hochfrequenztechnik, und die Miniaturisierung von Halbleiterbauteilen für die Hochfrequenztechnik weiter voranzubringen, zumal die erforderliche Mindestflächengröße der Halbleiterchips für ein Separieren und Bonden um mindestens eine Größenordnung durch die erfindungsgemäße Vorrichtung vermindert werden kann. Der Halbleiterchip hängt dabei während des Separierungsvorgangs an seiner Kontaktfläche. Die Kontaktfläche ist wiederum über einen Thermokompressionskopf mit dem Bonddraht verbunden. Der Halbleiterchip kann somit sicher zu dem Schaltungssubstrat in der Bestückungsstation transportiert, und dort auf einer entsprechenden Chipmontagefläche montiert werden. Dabei kann der Bonddraht, bzw. der Thermokompressionskopf, der sich bereits auf dem Halbleiterchip befindet, als Puffer zwischen dem Bondwerkzeug und dem Halbleiterchip dienen. Zum Abschluss des erfindungsgemäßen Verfahrens ist dann nur noch der Bonddraht auf der zur Verfügung stehenden Kontaktanschlussfläche, beispielsweise eines Innenflachleiters eines Flachleiterrahmens, aufzubonden.

Da mit herkömmlicher Technologie derart kleine Halbleiterchips weder separierbar, noch auf einem Schaltungssubstrat entsprechend bondbar sind, ist ein Nachweis, dass die Erfindungsidee von Wettbewerbern eingesetzt wird durch Messen der Halbleiterchipgrößen möglich. Ferner weist eine Deformierung des Thermokompressionskopfes auf ein zweifaches Einwirken des Bondwerkzeugs auf den Thermokompressionskopf hin, das dem erfindungsgemäßen Verfahren zugrunde liegt.

Die Erfindung wird nun anhand der beigefügten Figuren näher erläutert.
- Figur 1: zeigt eine Prinzipskizze einer Vorrichtung zum Singulieren und Bonden von Halbleiterchips, einer Ausführungsform der Erfindung;
- Figur 2: zeigt eine Prinzipskizze zu einem ersten Schritt eines Verfahrens zum Singulieren und Bonden von Halbleiterchips;
- Figur 3: zeigt eine Prinzipskizze zu einem zweiten Schritt des Verfahrens zum Singulieren und Bonden von Halbleiterchips;
- Figur 4: zeigt eine Prinzipskizze zu einem dritten Schritt des Verfahrens zum Singulieren und Bonden;
- Figur 5: zeigt eine Prinzipskizze zu einem vierten Schritt des Verfahrens zum Singulieren und Bonden;
- Figur 6: zeigt eine Prinzipskizze zu einem fünften Schritt des Verfahrens zum Singulieren und Bonden;
- Figur 7: zeigt eine Prinzipskizze zu einem sechsten Schritt des Verfahrens zum Singulieren und Bonden;
- Figur 8: zeigt eine Prinzipskizze zu einem siebten Schritt des Verfahrens zum Singulieren und Bonden.

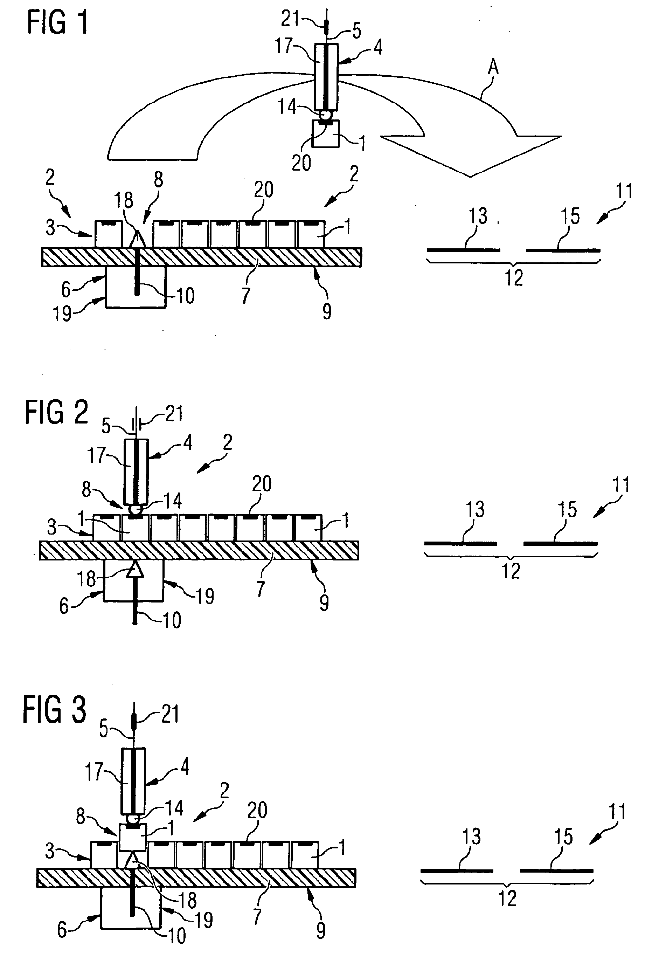

Figur 1 zeigt eine Prinzipskizze einer Vorrichtung zum Singulieren und Bonden von Halbleiterchips 1, einer Ausführungsform der Erfindung. Die Vorrichtung weist zwei Stationen auf, eine Singulierstation 2 und eine Bestückungsstation 11. Zwischen diesen beiden Stationen wird ein Bondwerkzeug 4 hin und her bewegt. Das Bondwerkzeug 4 nimmt unter Bonden in der Singulierstation 2 einen Halbleiterchip 1 auf, und transportiert ihn zu der Bestückungsstation 11.

Ein derartiges Bondwerkzeug 4 weist eine Bondkanüle 17 bzw. Bondkapillare oder einen Bondstichel auf, in der bzw. neben dem ein Bonddraht 5 geführt wird. In der Singulierstation 2 kann dieses Bondwerkzeug 4 auf eine Halbleiterchipposition 8 eines in Halbleiterchips 1 aufgetrennten Halbleiterwafers 3 ausgerichtet werden, sodass zunächst in der Singulierstation 2 das Bondwerkzeug 4 unmittelbar über der Halbleiterchipposition 8 angeordnet ist.

Der Halbleiterwafer 3 mit seinen Halbleiterchips 1 ist auf einem Trägersystem, wie einer Trägerfolie 7 fixiert oder angeordnet, die ihrerseits auf einem Singuliertisch 9 angeordnet sein kann. Gegenüberliegend zur Halbleiterchipposition 8 ist eine Abhebeeinrichtung 6 unter der Trägerfolie 7 angeordnet. Die Abhebeeinrichtung 6 weist eine Hubeinrichtung 10 mit oder ohne einer Hubnadel 18 auf. Die Hubeinrichtung kann auch beheizt sein, um das Abheben des Halbleiterchips zu erleichtern. Zwischen der Abhebeeinrichtung 6 und den in der Singulierstation 2 gegenüberliegend angeordneten Bondwerkzeug 4 ist der Singuliertisch 9 angeordnet.

Nach einem Bilden einer Bondperle 14 am Ende des Bonddrahtes 5, wie es beim Ball-Wedge-Verfahren auftritt, ist das Bondwerkzeug 4 in der Lage, einen Halbleiterchip 1 von dem Singuliertisch 9 mit Hilfe seines Bonddrahtes 5 und einer Klemmvorrichtung 21 für den Bonddraht 5 in Pfeilrichtung A in die Bestückungsstation 11 zu bringen. Das Abheben des Halbleiterchips 1 von der Trägerfolie 9 oder einem Systemträger, in dieser Ausführungsform der Erfindung, wird durch eine Heizvorrichtung 19 der Abhebeeinrichtung 6 im Bereich des abzuhebenden Halbleiterchips 1 erleichtert. Durch diese Heizvorrichtung 19 wird die Ablösearbeit der Hubeinrichtung 10 mit seiner Hubnadel 18 verringert, so dass ein problemloses Ablösen des Halbleiterchips 1 von der Trägerfolie 7 möglich wird.

Die Bestückungsstation 11 weist einen hier nicht gezeigten Halter auf, der einen Schaltungsträger 12 hält, welcher eine Chipmontagefläche 13 und mindestens eine Kontaktanschlussfläche 15 aufweist.

Sobald der bereits an dem Bonddraht 5 hängende Halbleiterchip 1 durch die Bewegung in Pfeilrichtung A des Bondwerkzeugs 4 auf die Chipmontagefläche 13 der Bestückungsstation 11 verbracht worden ist, kann der Halbleiterchip 1 auf der Chipmontagefläche 13 mit den unterschiedlichsten Maßnahmen gebondet werden. Dazu kann die Chipmontagefläche 13 mit einer Klebeschicht versehen sein, oder eine bondbare oder auch Lötbare Beschichtung aufweisen. Mittels Thermokompressionsbonden kann der Halbleiterchip 1 mit seiner Rückseite auf der Chipmontagefläche 13 über, beispielsweise Bildung einer eutektischen Schmelze, oder über die Bildung einer Lotschmelze befestigt werden.

Da der Bonddraht 5 in der Bondkanüle 17 bzw. in dem Bondstichel bereits mit dem Halbleiterchip 1 an dessen Kontaktfläche 20 verbunden ist, kann nach dem Fixieren des Halbleiterchips 1 auf der Chipmontagefläche 13 der Bonddraht 5 zur Kontaktanschlussfläche 15 hinüber gezogen werden, und damit die Bondverbindung vollendet werden. Dieser Zyklus kann so lange wiederholt werden, bis sämtliche funktionsfähigen Halbleiterchips 1 des Halbleiterwafers 3 von der Singulierstation 2 zu der Bestückungsstation 11 verbracht worden sind, und dort fertig gebondet wurden.

Mit dieser Vorrichtung können im Extremfall die erforderlichen Mindestflächengrößen für einen Transport von einer Singulierstation 2 zu einer Bestückungsstation 11 mindestens um eine Größenordnung gegenüber den herkömmlichen Vorrichtungen vermindert werden. Ein weiterer Vorteil dieser Erfindung ist es, dass bereits ein erstes Bonden eines Bonddrahtes 5 an einem Halbleiterchip 1 auf die mindestens eine Kontaktfläche 20 beim Separieren erfolgt ist. Die Kombination aus der Aufteilung der Bondschritte auf einen ersten Bondschritt, der gleichzeitig mit einem Singulierungsschritt für Halbleiterchips 1 von einem Halbleiterwafer 3 verbunden ist, und der Verlegung der zweiten Bondstelle in die Bestückungsstation 11 wird erstmalig für Halbleiterchips 1 mit minimalen Kantenabmessungen eine erste Möglichkeit geschaffen, zuverlässig in Kleinstabmessungen in einer Bestückungsstation 11 gebondet zu werden, und in einer Singulierstation 2 von einer Trägerfolie 7 abgehoben zu werden.

Figuren 2 bis 8 zeigen Prinzipskizzen von Verfahrensschritten für die Verwendung der erfindungsgemäßen Vorrichtung, gemäß Figur 1, für den Zyklus zum Singulieren und Bonden eines ersten Halbleiterchips 1. Dieser Zyklus der Figuren 2 bis 8 kann beliebig wiederholt werden, bis sämtliche Halbleiterchips 1 eines Halbleiterwafers 3 verarbeitet sind. Komponenten mit gleichen Funktionen wie in Figur 1 werden in den Figuren 2 bis 8 mit gleichen Bezugszeichen gekennzeichnet und nicht extra erörtert.

Figur 2 zeigt eine Prinzipskizze zu einem ersten Schritt eines Verfahrens zum Singulieren und Bonden eines Halbleiterchips 1 eines in Halbleiterchips 1 aufgetrennten Halbleiterwafers 3. Zu Beginn des erfindungsgemäßen Verfahrens wird zunächst in die Bondkanüle 17 der Bonddraht 5 bei geöffneter Klemmvorrichtung 21 eingeführt. Das aus der Bondkanüle 17 herausragende Ende des Bonddrahts 5 wird noch vor dem Aufsetzen auf einen Halbleiterchip 1 durch Aufschmelzen in eine Bondperle 14 umgesetzt.

Beim Aufsetzen der Bondkanüle 17 auf eine Kontaktfläche 20 eines Halbleiterchips 1 in der Halbleiterbauteilposition 8 wird durch Thermokompression und Ultraschall die Bondperle 14 in einen Thermokompressionskopf umgesetzt, und gleichzeitig das Material des Bonddrahtes 5 mit dem Material der Kontaktfläche 20 verschmolzen. Die Energie wird dabei teilweise durch Reibenergie aufgrund von Ultraschallbewegungen und teilweise durch Wärmezufuhr und schließlich durch den Anpressdruck der Bondperle 14 auf die Kontaktanschlussfläche 15 aufgebracht.

In diesem Ausführungsbeispiel weist die Kontaktfläche 20 eine Aluminiumlegierung auf, und der Bonddraht 5 besteht aus Gold, Aluminium oder Legierungen derselben, so dass beim Thermokompressionsbonden eine eutektische Schmelze bereits bei niedriger Temperatur auftritt, und die beiden Grenzflächen zusammenlötet. Damit ist in der Singulierstation 2, wie sie Figur 2 zeigt, ein Zustand erreicht, bei dem der Halbleiterchip 1 über die Kontaktfläche 20 mit dem Bonddraht 5 fest verbunden ist. Damit beim Abheben des Halbleiterchips 1 diese Verbindung zwischen Bonddraht 5 und Halbleiterchip 1 nicht delaminiert oder abreißt, ist unterhalb des Singuliertisches 9 eine Abhebeeinrichtung 6 angebaut, die mehrere Funktionen durchführen kann.

Einmal kann mit Hilfe einer Heizvorrichtung 19 der gesamte Bereich in der Nähe der Halbleiterchipposition 8 aufgeheizt werden und damit ein Verflüssigen oder verglasen der Adhäsionsschicht zwischen Trägerfolie 7 und Halbleiterchip 1 auftreten. Darüber hinaus weist diese Abhebeeinrichtung 6 eine Hubeinrichtung 10 auf, die in ihrer Spitze eine Hubnadel 18 aufweist, welche durch die Trägerfolie 7 hindurch stechen kann, und den Halbleiterchips 1, der an dem Bonddraht 5 befestigt ist, von der Trägerfolie 7 abheben. Gleichzeitig wird für diesen Abhebevorgang die Klemmvorrichtung 21, die in Figur 2 noch geöffnet gezeigt wird, geschlossen, wie es dann Figur 3 zeigt.

Figur 3 zeigt eine Prinzipskizze eines zweiten Schrittes des Verfahrens zum Singulieren und Bonden, gemäß einer Ausführungsform der Erfindung. Die Hubnadel 18 hat nun in der Singulierstation 2 das Trägersubstrat durchstoßen und den Halbleiterchip 1 so weit von der Klebeschicht der Trägerfolie 7 abgehoben, dass nun das Bondwerkzeug 4 den Halbleiterchip 1 an seiner Kontaktfläche 20 von dem Halbleiterwafer 3 singulieren kann.

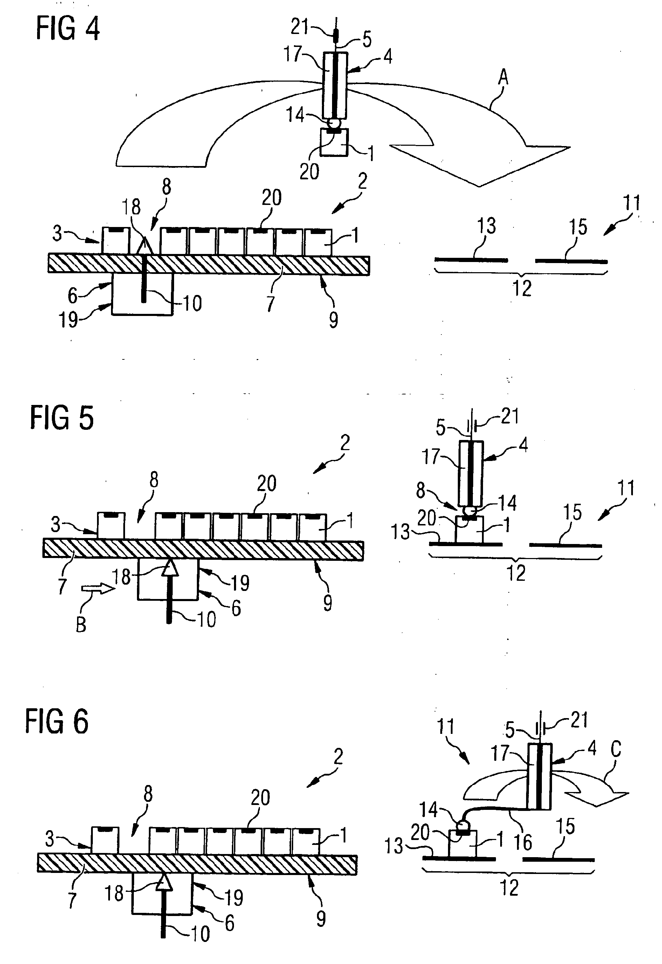

Figur 4 zeigt eine Prinzipskizze eines dritten Schrittes eines Verfahrens zum Singulieren und Bonden von Halbleiterchips 1, wobei die Figur 4 der Figur 1 entspricht, und einen Zustand zeigt, bei dem das Bondwerkzeug 4 bereits eine Zwischenposition zwischen der Singulierstation 2 und der Bestückungsstation 11 erreicht hat. Dabei ist die Klemmvorrichtung 21, wie in Figur 3 geschlossen, und hält somit den Halbleiterchip 1 an dem Bonddraht 5 fest, so dass er während des Transports von der Singulierstation 2 zu der Bestückungsstation 11 nicht abfallen kann.

Figur 5 zeigt eine Prinzipskizze eines vierten Schrittes eines Verfahrens zum Singulieren und Bonden, wobei das Bondwerkzeug 4 bereits die Bestückungsstation 11 erreicht hat und auf die Chipmontagefläche 13 des Schaltungsträgers 12 über dem Halbleiterchip 1 abgesenkt hat. Die Klemmvorrichtung 21 wird geöffnet und gibt den Bonddraht 5 frei, so dass ein erneutes Bonden erfolgen kann. Bei diesem Thermokompressionsbonden wird die Rückseite des Halbleiterchips 1 auf der Chipmontagefläche 13 des Schaltungsträges 12 beispielsweise durch Thermokompressionsbonden fixiert. Gleichzeitig ist die Abhebeeinrichtung 6 in der Singulierstation 2 eine Position weiter gerückt, in Pfeilrichtung B, vorbereitend für den nächsten Bondzyklus.

Figur 6 zeigt eine Prinzipskizze zu einem fünften Schritt des Verfahrens zum Singulieren und Bonden. Die Klemmvorrichtung 21 an dem Bondwerkzeug 4 ist geöffnet, so dass die Bondkanüle 17 an der Chipmontagefläche 13 zu der Kontaktanschlussfläche 15 unter Bilden eines Bondbogens 16 in Pfeilrichtung C bewegt werden kann, ohne dass der Bonddraht 5 abreißt. Die Situation in der Singulierstation 2 bleibt während dieses Vorgangs unverändert.

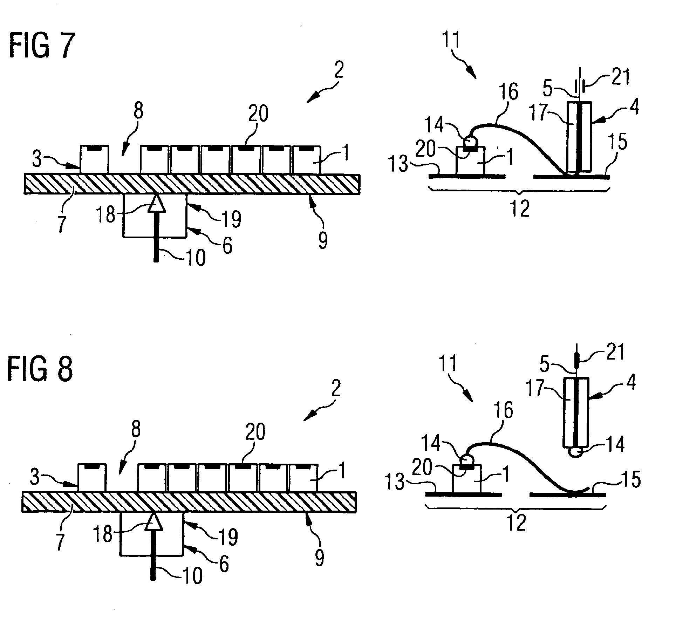

Figur 7 zeigt eine Prinzipskizze zu einem sechsten Schritt des Verfahrens zum Singulieren und Bonden. Bei diesem sechsten Schritt wird durch einen Thermokompressionsvorgang, der mit einem Ultraschall überlagert sein kann, das Ende des Bonddrahtes 5 auf der Kontaktanschlussfläche 15 befestigt. Direkt danach kann die Klemmvorrichtung 21 geschlossen werden wie es Figur 8 zeigt.

Figur 8 zeigt eine Prinzipskizze zu einem siebten Schritt des Verfahrens. Bei diesem siebten Schritt durchtrennt das Bondwerkzeug 4 den Bonddraht 5 des Bondbogens 16. Dazu wird die Klemmvorrichtung 21 geschlossen. Ein Zündfunke wird auf den Bonddraht 5 gerichtet und unter Bildung einer Bondperle 14 wird der Bonddraht 5 aufgetrennt. Damit ist das Bondwerkzeug 4 bereit, den nächsten Halbleiterchip 1 von der Trägerfolie 7, wie in Figur 2 gezeigt, zu singulieren. Dieser Zyklus wird so lange fortgesetzt, bis alle funktionsfähigen Halbleiterchips 1 von der Trägerfolie 7 singuliert wurden, und in der Bestückungsstation 11 auf einem Schaltungsträger 12 gebondet wurden.

## Patentansprüche

1. Vorrichtung zum Singulieren und Bonden von Halbleiterchips (1) mit
- einer Singulierstation (2) für Halbleiterchips (1) eines Halbleiterwafers (3) mit einem Bondwerkzeug (4) zum Fixieren eines Bonddrahts (5) auf einem Halbleiterchip (1) und einer Abhebeeinrichtung (6) zum Abheben eines Halbleiterchips (1) von einer mit Halbleiterchips (1) eines Halbleiterwafers (3) bedeckten Trägerfolie (7), wobei das Bondwerkzeug (4) und die Abhebeeinrichtung (6) einander gegenüberliegend auf eine Halbleiterchipposition (8) eines Singuliertisches (9) für einen in Halbleiterchips (1) getrennten Halbleiterwafer (3) ausrichtbar sind, und wobei der Singuliertisch (9) zwischen Bondwerkzeug (4) und einer Hubeinrichtung (10) der Abhebeeinrichtung (6) angeordnet ist;
- einer Bestückungsstation (11), mit einem Schaltungsträger (12), der eine Chipmontagefläche (13) zur Aufnahme eines an einen Bonddraht (5) des Bondwerkzeugs (4) gebondeten Halbleiterchips (1), und der mindestens eine Kontaktanschlussfläche (15) zum Aufbonden des Bonddrahtes (5) des Bondwerkzeugs (4) auf die Kontaktanschlussfläche (15) aufweist;
- einem Hub- und Transportmechanismus mit Steuerungsvorrichtung zum Steuern und Ausführen von Bewegungen des Bondwerkzeugs (4), des Singuliertisches (9), der Abhebeeinrichtung (6) und des Schaltungsträgers (12).

2. Vorrichtung nach Anspruch 1,
**dadurch gekennzeichnet, dass**
das Bondwerkzeug (4) eine zentrale Bondkanüle (17) oder einen Bondstichel aufweist, in welcher bzw. seitlich neben dem der Bonddraht (5) angeordnet ist.

3. Vorrichtung nach Anspruch 1 oder Anspruch 2,
**dadurch gekennzeichnet, dass**
das Bondwerkzeug (4) eine Bondperle (14) des Bonddrahts (5) bildende Abschmelzeinrichtung aufweist.

4. Vorrichtung nach einem der vorhergehenden Ansprüche,
**dadurch gekennzeichnet, dass**
die Abhebeeinrichtung (6) eine Hubnadel (18) aufweist, die auf den abzuhebenden Halbleiterchip (1) ausgerichtet ist und vorgesehen ist, die Trägerfolie (7) durchzustechen und den Halbleiterchip (1) von der Trägerfolie (7) abzuheben.

5. Vorrichtung nach einem der vorhergehenden Ansprüche,
**dadurch gekennzeichnet, dass**
die Abhebeeinrichtung (6) eine Heizvorrichtung (19) aufweist, welche auf die Trägerfolie (7) im Bereich des abzuhebenden Halbleiterchip (1) ausgerichtet ist.

6. Vorrichtung nach einem der vorhergehenden Ansprüche,
**dadurch gekennzeichnet, dass**
die Bestückungsstation (11) einen Halter für einen Flachleiterrahmen aufweist, der als Schaltungsträger (12) mit Halbleiterchips zu bestücken ist.

7. Vorrichtung nach einem der Ansprüche 1 bis 5,
**dadurch gekennzeichnet, dass**
die Bestückungsstation(11) einen Halter für einen Nutzen aufweist, der als Schaltungsträger (12) mit Halbleiterchips (1) zu bestücken ist.

8. Vorrichtung nach einem der Ansprüche 1 bis 5,
**dadurch gekennzeichnet, dass**
die Bestückungsstation (11) einen Halter für ein Umverdrahtungssubstrat aufweist, das als Schaltungsträger (12) mit einem Halbleiterchip (1) zu bestücken ist.

9. Vorrichtung nach einem der Ansprüche 1 bis 5,
**dadurch gekennzeichnet, dass**
die Bestückungsstation (11) einen Halter für ein Hochfrequenzgehäuse aufweist, das als Schaltungsträger (12) mit einem Halbleiterchip (1) zu bestücken ist.

10. Vorrichtung nach einem der Ansprüche 1 bis 5,
**dadurch gekennzeichnet, dass**
die Bestückungsstation (11) einen Halter für ein Hochfrequenz PIN-Diodengehäuse aufweist, das als Schaltungsträger (12) mit einem Halbleiterchip (1) zu bestücken ist.

11. Verfahren zum Singulieren und Bonden von Halbleiterchips (1) eines in Halbleiterchips (1) aufgetrennten Halbleiterwafers (3), wobei das Verfahren folgende Verfahrensschritte aufweist:
- Positionieren eines auf einer Trägerfolie (7) fixierten in Halbleiterchips (1) aufgetrennten Halbleiterwafers (3) auf einem Singuliertisch (9) einer Singulierstation (2),
- Ausrichten eines Bondwerkzeugs (4) mit Bonddraht (5) über einem der Halbleiterchips (1) auf dem Singuliertisch (9);
- Bilden einer Bondperle (14) am Ende des Bonddrahtes (5);
- Absenken des Bondwerkzeugs (4) auf den Halbleiterchip (1) unter Bonden der Bondperle (14) auf eine Kontaktfläche (20) des Halbleiterchips (1)
- Abheben des Bondwerkzeugs (4) mit am Bonddraht (5) hängendem Halbleiterchip (1) von der Trägerfolie (7);
- Transportieren des Halbleiterchips (1) an dem Bonddraht (5) des Bondwerkzeugs (4) zu einer Bestückungsstation (11), die einen Schaltungsträger (12) mit einer Chipmontagefläche (13) und mindestens eine Kontaktanschlussfläche (15) aufweist,
- Fixieren des Halbleiterchips (1) auf der Chipmontagefläche (13) mittels des Bondwerkzeugs (4),
- Führen des Bonddrahtes (5) mittels des Bondwerkzeugs (4) von der Chipmontagefläche (13) zu der Kontaktanschlussfläche (15), und
- Bonden des Bonddrahtes (5) auf der Kontaktanschlussfläche (15).

12. Verfahren nach Anspruch 11,
**dadurch gekennzeichnet, dass**
vor dem Positionieren des Halbleiterwafers (3) ein Auftrennen des Halbleiterwafers (3) in Halbleiterchips (1) auf dem Singuliertisch (9) mittels Diamantsägen oder Laserstrahltrennung erfolgt.

13. Verfahren nach Anspruch 11 oder Anspruch 12,
**dadurch gekennzeichnet, dass**
vor dem Ausrichten des Bondwerkzeugs (4) über einem der Halbleiterchips (1) auf dem Singuliertisch (9) ein Bonddraht (5) in eine zentrale Bondkanüle (17) des Bondwerkzeugs (4) oder neben einem Bondstichel eingeführt wird.

14. Verfahren nach einem der Ansprüche 11 bis 13,
**dadurch gekennzeichnet, dass**
zum Bilden einer Bondperle (14) am Ende des Bonddrahtes (5) eine Flamme oder ein Zündfunke auf das Bonddrahtende gerichtet wird.

15. Verfahren nach einem der Ansprüche 11 bis 13,
**dadurch gekennzeichnet, dass**
zum Bilden einer Bondperle (14) am Ende des Bonddrahtes (5) ein induktives Heizen durchgeführt wird.

16. Verfahren nach einem der Ansprüche 11 bis 15,
**dadurch gekennzeichnet, dass**
zum Bonden der Bondperle (14) auf eine Kontaktfläche (20) des Halbleiterchips (1) ein Thermokompressionssonicbonden erfolgt.

17. Verfahren nach einem der Ansprüche 11 bis 16,
**dadurch gekennzeichnet, dass**
vor dem Abheben des Bondwerkzeugs (4) mit am Bonddraht (5) hängendem Halbleiterchip (1) von der Trägerfolie (7), die Trägerfolie (7) im Bereich des Halbleiterchips (1) aufgeheizt wird.

18. Verfahren nach einem der Ansprüche 11 bis 16,
**dadurch gekennzeichnet, dass**
zum Fixieren des Halbleiterchips (1) auf der Chipmontagefläche (13) mittels des Bondwerkzeugs (4) ein Andrücken des Halbleiterchips (1) auf eine Klebstoffschicht der Chipmontagefläche (13) erfolgt.

19. Verfahren nach einem der Ansprüche 11 bis 18,
**dadurch gekennzeichnet, dass**
zum Fixieren des Halbleiterchips (1) auf der Chipmontagefläche (13) mittels des Bondwerkzeugs (4) ein Aufheizen einer Lotschicht auf der Chipmontagefläche (13) und gleichzeitig im Andrücken des Halbleiterchips (1) auf die angeschmolzene Lotschicht oder die angeschmolzene eutektische Schicht erfolgt.

20. Verfahren nach einem der Ansprüche 11 bis 18,
**dadurch gekennzeichnet, dass**
das Bonden des Bonddrahtes (5) auf der Kontaktanschlussfläche (15) mittels Thermokompressionssonicbonden eines Bondbogens (16) auf der Kontaktanschlussfläche (15) erfolgt.

## Claims

1. Apparatus for singulating and bonding semiconductor chips (1), having
- a singulating station (2) for singulating semiconductor chips (1) of a semiconductor wafer (3), having a bonding tool (4) for fixing a bonding wire (5) on a semiconductor chip (1) and a lift-off device (6) for lifting a semiconductor chip (1) off a carrier film (7) which has been covered with semiconductor chips (1) of a semiconductor wafer (3), it being possible for the bonding tool (4) and the lift-off device (6) to be aligned opposite one another toward a semiconductor chip position (8) of a singulating table (9) for a semiconductor wafer (3) which has been divided into semiconductor chips (1), and the singulating table (9) being arranged between bonding tool (4) and a raising device (10) of the lift-off device (6);
- a mounting station (11), having a circuit carrier (12), which includes a chip mounting surface (13) for receiving a semiconductor chip (1) which has been bonded to a bonding wire (5) of the bonding tool (4), and includes at least one contact-connection surface (15) for the bonding wire (5) of the bonding tool (4) to be bonded onto the contact-connection surface (15);
- a raising and conveying mechanism with control apparatus for controlling and executing movements of the bonding tool (4), the singulating table (9), the lift-off device (6) and the circuit carrier (12).

2. Apparatus according to Claim 1, **characterized in that** the bonding tool (4) has a central bonding capillary (17) or a bonding stylus, in which capillary or laterally next to which stylus the bonding wire (5) is arranged.

3. Apparatus according to Claim 1 or Claim 2, **characterized in that** the bonding tool (4) has a melting device which forms a bonding bead (14) of the bonding wire (5).

4. Apparatus according to one of the preceding claims, **characterized in that** the lift-off device (6) includes a raising needle (18) which is directed onto the semiconductor chip (1) that is to be lifted off and is intended to puncture the carrier film (7) and lift the semiconductor chip (1) off the carrier film (7).

5. Apparatus according to one of the preceding claims, **characterized in that** the lift-off device (6) includes a heating apparatus (19) which is directed onto the carrier film (7) in the region of the semiconductor chip (1) that is to be lifted off.

6. Apparatus according to one of the preceding claims, **characterized in that** the mounting station (11) includes a holder for a leadframe, which as circuit carrier (12) is to have semiconductor chips mounted on it.

7. Apparatus according to one of Claims 1 to 5, **characterized in that** the mounting station (11) includes a holder for a panel which as circuit carrier (12) is to have semiconductor chips (1) mounted on it.

8. Apparatus according to one of Claims 1 to 5, **characterized in that** the mounting station (11) includes a holder for a rewiring substrate, which as circuit carrier (12) is to have a semiconductor chip (1) mounted on it.

9. Apparatus according to one of Claims 1 to 5, **characterized in that** the mounting station (11) includes a holder for a radiofrequency housing, which as circuit carrier (12) is to have a semiconductor chip (1) mounted on it.

10. Apparatus according to one of Claims 1 to 5, **characterized in that** the mounting station (11) includes a holder for a radiofrequency PIN diode housing, which as circuit carrier (12) is to have a semiconductor chip (1) mounted on it.

11. Method for singulating and bonding semiconductor chips (1) of a semiconductor wafer (3) that has been divided into semiconductor chips (1), the method including the following method steps:
- positioning a semiconductor wafer (3) which has been fixed on a carrier film (7) and divided into semiconductor chips (1) on a singulating table (9) of a singulating station (2),
- aligning a bonding tool (4) with bonding wire (5) above one of the semiconductor chips (1) on the singulating table (9);
- forming a bonding bead (14) at the end of the bonding wire (5);
- lowering the bonding tool (4) onto the semiconductor chip (1), so as to bond the bonding bead (14) onto a contact surface (20) of the semiconductor chip (1)
- lifting the bonding tool (4) with semiconductor chip (1) suspended from the bonding wire (5) off the carrier film (7);
- conveying the semiconductor chip (1) on the bonding wire (5) of the bonding tool (4) to a mounting station (11), which includes a circuit carrier (12) with a chip mounting surface (13) and at least one contact-connection surface (15),
- fixing the semiconductor chip (1) on the chip mounting surface (13) by means of the bonding tool (4),
- guiding the bonding wire (5) by means of the bonding tool (4) from the chip mounting surface (13) to the contact-connection surface (15), and
- bonding the bonding wire (5) on the contact-connection surface (15).

12. Method according to Claim 11, **characterized in that** prior to the step of positioning the semiconductor wafer (3), the semiconductor wafer (3) is divided into semiconductor chips (1) on the singulating table (9) by means of diamond sawing or laser beam separation.

13. Method according to Claim 11 or 12, **characterized in that** prior to the step of aligning the bonding tool (4) above one of the semiconductor chips (1) on the singulating table (9), a bonding wire (5) is introduced into a central bonding capillary (17) of the bonding tool (4) or next to a bonding stylus.

14. Method according to one of Claims 11 to 13, **characterized in that** a flame or an ignition spark is directed onto the end of the bonding wire (5) in order to form a bonding bead (14) at the bonding wire end.

15. Method according to one of Claims 11 to 13, **characterized in that** inductive heating is carried out to form a bonding bead (14) at the end of the bonding wire (5).

16. Method according to one of Claims 11 to 15, **characterized in that** thermocompression sonic bonding is carried out to bond the bonding bead (14) onto a contact surface (20) of the semiconductor chip (1).

17. Method according to one of Claims 11 to 16, **characterized in that** prior to the step of lifting the bonding tool (4) with semiconductor chip (1) suspended from the bonding wire (5) off the carrier film (7), the carrier film (7) is heated in the region of the semiconductor chip (1).

18. Method according to one of Claims 11 to 16, **characterized in that** to fix the semiconductor chip (1) on the chip mounting surface (13) by means of the bonding tool (4), the semiconductor chip (1) is pressed onto a layer of adhesive on the chip mounting surface (13).

19. Method according to one of Claims 11 to 18, **characterized in that** to fix the semiconductor chip (1) on the chip mounting surface (13) by means of the bonding tool (4), a layer of solder on the chip mounting surface (13) is heated and at the same time the semiconductor chip (1) is pressed onto the molten layer of solder or the molten eutectic layer.

20. Method according to one of Claims 11 to 18, **characterized in that** the bonding of the bonding wire (5) on the contact-connection surface (15) is carried out by thermocompression sonic bonding of a bonding clip (16) on the contact-connection surface (15).

## Revendications

1. Dispositif pour séparer et souder des puces semi-conductrices (1) avec
- une station de séparation (2) pour des puces semi-conductrices (1) d'une galette semi-conductrice (3) avec un outil de soudage (4) pour fixer un fil de soudage (5) sur une puce semi-conductrice (1) et une installation de prélèvement (6) pour prélever une puce semi-conductrice (1) depuis une feuille de support (7) recouverte par les puces semi-conductrices (1) d'une galette semi-conductrice (3), l'outil de soudage (4) et l'installation de prélèvement (6) étant disposés vis-à-vis l'un de l'autre et pouvant être dirigés sur une position de puce semi-conductrice (8) d'une table de séparation (9) d'une galette semi-conductrice (3) subdivisée en puces semi-conductrices (1), et la table de séparation (9) étant disposée entre l'outil de soudage (4) et une installation de soulèvement (10) de l'installation de prélèvement (6) ;
- une station de placement de composants (11) avec un support de circuit (12) qui comporte une surface de montage de puce (13) pour recevoir une puce semi-conductrice (1) soudée à un fil de soudage (5) de l'outil de soudage (4), et qui comporte au moins une surface de raccordement du contact (15) pour le soudage du fil de soudage (5) de l'outil de soudage (4) sur la surface de raccordement du contact (15) ;
- un mécanisme de soulèvement et de transport avec un dispositif de commande pour la commande et l'exécution de déplacements de l'outil de soudage (4), de la table de séparation (9), de l'installation de prélèvement (6) et du support de circuit (12).

2. Dispositif selon la revendication 1, **caractérisé en ce que** l'outil de soudage (4) comporte une canule de soudage centrale (17) ou un poinçon de soudage dans laquelle, respectivement à côté duquel est disposé le fil de soudage (5).

3. Dispositif selon la revendication 1 ou la revendication 2, **caractérisé en ce que** l'outil de soudage (4) comporte une installation de fusion formant une perle de soudage (14) du fil de soudage (5).

4. Dispositif selon une des revendications précédentes, **caractérisé en ce que** l'installation de prélèvement (6) comporte une aiguille de soulèvement (18) qui est dirigée vers la puce semi-conductrice (1) à prélever et qui est prévue pour percer la feuille de support (7) et pour prélever la puce semi-conductrice (1) à partir de la feuille de support (7).

5. Dispositif selon une des revendications précédentes, **caractérisé en ce que** l'installation de prélèvement (6) comporte un dispositif de chauffage (19) dirigé vers la feuille de support (7) dans la zone de la puce semi-conductrice (1) à prélever.

6. Dispositif selon une des revendications précédentes, **caractérisé en ce que** l'installation de placement (11) comporte une fixation pour un cadre à conducteurs plats qui sert de support de circuit (12) à équiper de puces semi-conductrices.

7. Dispositif selon une des revendications 1 à 5, **caractérisé en ce que** l'installation de placement (11) comporte une fixation pour une plaque qui sert de support de circuit (12) à équiper de puces semi-conductrices (1).

8. Dispositif selon une des revendications 1 à 5, **caractérisé en ce que** l'installation de placement (11) comporte une fixation pour un substrat d'interconnexion qui sert de support de circuit (12) à équiper d'une puce semi-conductrice (1).

9. Dispositif selon une des revendications 1 à 5, **caractérisé en ce que** l'installation de placement (11) comporte une fixation pour un boîtier de hautes fréquences qui sert de support de circuit (12) à équiper d'une puce semi-conductrice (1).

10. Dispositif selon une des revendications 1 à 5, **caractérisé en ce que** l'installation de placement (11) comporte une fixation pour un boîtier de diode PIN à hautes fréquences qui sert de support de circuit (12) à équiper d'une puce semi-conductrice (1).

11. Procédé pour séparer et souder des puces semi-conductrices (1) d'une galette semi-conductrice (3) subdivisée en puces semi-conductrices (1), le procédé comportant les étapes suivantes du procédé :
- positionner une galette semi-conductrice (3) fixée sur une feuille de support (7), subdivisée en puces semi-conductrices (1), sur une table de séparation (9) d'une station de séparation (2) ;
- diriger un outil de soudage (4) avec le fil de soudage (5) au-dessus d'une puce semi-conductrice (1) sur la table de séparation (9) ;
- former une perle de soudage (14) à l'extrémité du fil de soudage (5) ;
- abaisser l'outil de soudage (4) sur la puce semi-conductrice (1) pour souder la perle de soudage (14) sur une surface de contact (20) de la puce semi-conductrice (1) ;
- relever l'outil de soudage (4) depuis la feuille de support (7) avec la puce semi-conductrice (1) suspendue au fil de soudage (5) ;
- transporter la puce semi-conductrice (1) par le fil de soudage (5) de l'outil de soudage (4) vers une station de placement (11) qui comporte un support de circuit (12) avec une surface de montage de puce (13) et au moins une surface de raccordement de contact (15) ;
- fixer la puce semi-conductrice (1) sur la surface de montage de puce (13) au moyen de l'outil de soudage (4) ;
- guider le fil de soudage (5) au moyen de l'outil de soudage (4) depuis la surface de montage de puce (13) vers la surface de raccordement de contact (15) ; et
- souder le fil de soudage (5) sur la surface de raccordement de contact (15).

12. Procédé selon la revendication 11, **caractérisé en ce qu'**avant le positionnement de la galette semi-conductrice (3), on réalise un découpage de la galette semi-conductrice (3) en puces semi-conductrices (1) sur la table de séparation (9) au moyen de scies en diamant ou par découpe laser.

13. Procédé selon la revendication 11 ou la revendication 12, **caractérisé en ce qu'**avant de diriger l'outil de soudage (4) au-dessus d'une puce semi-conductrice (1) sur la table de séparation (9), on engage un fil de soudage (5) dans une canule de soudage centrale (17) de l'outil de soudage (4) ou à côté d'un poinçon de soudage.

14. Procédé selon une des revendications 11 à 13, **caractérisé en ce que** pour former une perle de soudage (14) à l'extrémité du fil de soudage (5), on dirige une flamme ou une étincelle d'amorçage sur l'extrémité de soudage du fil.

15. Procédé selon une des revendications 11 à 13, **caractérisé en ce que** pour former une perle de soudage (14) à l'extrémité du fil de soudage (5), on effectue un chauffage par induction.

16. Procédé selon une des revendications 11 à 15, **caractérisé en ce que** pour souder la perle de soudage (14) sur une surface de contact (20) de la puce semi-conductrice (1), on réalise un soudage par thermocompression basé sur les ultrasons.

17. Procédé selon une des revendications 11 à 16, **caractérisé en ce qu'**avant de relever l'outil de soudage (4) depuis la feuille de support (7) avec la puce semi-conductrice (1) suspendue au fil de soudage (5), on chauffe la feuille de support (7) dans la zone de la puce semi-conductrice (1).

18. Procédé selon une des revendications 11 à 16, **caractérisé en ce que** pour fixer la puce semi-conductrice (1) sur la surface de montage de puce (13) au moyen de l'outil de soudage (4), on exerce une pression de la puce semi-conductrice (1) sur une couche de colle de la surface de montage de puce (13).

19. Procédé selon une des revendications 11 à 18, **caractérisé en ce que** pour fixer la puce semi-conductrice (1) sur la surface de montage de puce (13) au moyen de l'outil de soudage (4), on effectue un chauffage d'une couche de soudure sur la surface de montage de puce (13) et simultanément on exerce une pression de la puce semi-conductrice (1) sur la couche de soudure fondue ou sur la couche eutectique fondue.

20. Procédé selon une des revendications 11 à 18, **caractérisé en ce qu'**on effectue le soudage du fil de soudage (5) sur la surface de raccordement de contact (15) au moyen du soudage d'une boucle de soudage (16) sur la surface de raccordement de contact (15) par thermocompression basé sur les ultrasons.
